# EUROPEAN PATENT APPLICATION

(11) **EP 4 712 726 A1**
(43) Date of publication of application: **18.03.2026**
(21) Application number: 25200967.5
(22) Date of filing: 09.09.2025
(51) Int. Cl.: H10D 62/13, H10D 30/01, H10D 30/43, H10D 30/00, H10D 84/01, H10D 84/83, H10D 88/00

(54) **STACKED SEMICONDUCTOR DEVICE MANUFACTURED USING DUMMY CHANNEL STACK AND BARRIER LAYER**

(30) Priority: 11.09.2024 US 202463693557 P; 11.03.2025 US 202519076480
(71) Applicant: SAMSUNG ELECTRONICS CO., LTD., Yeongtong-gu Suwon-si, Gyeonggi-do 16677 (KR)
(72) Inventor: PARK, Kibyung, San Jose, CA, 95134 (US); SEO, Kang-Ill, San Jose, CA, 95134 (US)
(74) Representative: Kuhnen & Wacker Patent- und Rechtsanwaltsbüro PartG mbB

(57) **Abstract**

Provided is a stacked semiconductor device which includes: a substrate; a 1^{st} source/drain region on the substrate; and a 2^{nd} source/drain region vertically above the 1^{st} source/drain region, the 2^{nd} source/drain region vertically overlapping a 1^{st} portion, among the 1^{st} portion and a 2^{nd} portion, of the 1^{st} source/drain region, wherein a 1^{st} portion of a top surface of the substrate vertically below the 1^{st} portion of the 1^{st} source/drain region and a 2^{nd} portion of the top surface of the substrate vertically below the 2^{nd} portion of the 1^{st} source/drain region are coplanar or aligned.

## Description

### BACKGROUND

### 1. Field

Apparatuses and methods consistent with the disclosure relate to a semiconductor device, more particularly, a stacked semiconductor device including a 1^{st} transistor and a 2^{nd} transistor formed vertically above the 1^{st} transistor and a method of manufacturing the same.

### 2. Description of Related Art

A stacked semiconductor device has been introduced in response to increased demand for an integrated circuit with a high device density and performance. The stacked semiconductor device may include a 1^{st} transistor at a 1^{st} level and a 2^{nd} transistor at a 2^{nd} level above the 1^{st} level, where each of the two transistors may be a field-effect transistor (FET) such as fin field-effect transistor (FinFET), nanosheet transistor, forksheet transistor, or any other type of FET.

The FinFET has one or more fin structures, which are protruded from a substrate, as a channel structure and a gate structure surrounding at least three surfaces of each of the fin structures. The nanosheet transistor is characterized by one or more nanosheet channel layers, which are vertically stacked or arranged on a substrate, as a channel structure and a gate structure surrounding all four surfaces of each of the nanosheet channel layers. The nanosheet transistor is referred to as gate-all-around (GAA) transistor, or as a multi-bridge channel field-effect transistor (MBCFET). The forksheet transistor is a combination of two nanosheet transistors with an insulation backbone structure therebetween. In the forksheet transistor, nanosheet channel layers of each nanosheet transistor are formed at each side of the insulation backbone structure and pass through a gate structure in parallel with the backbone structure

In the stacked semiconductor device, the 1^{st} transistor and the 2^{nd} transistor vertically thereabove may be formed to have different dimensions, for example, different widths in channel structure and source/drain region to facilitate formation of a contact structure and achieve optimal device performance. However, because of a complex device structure and a high-aspect ratio, formation of the stacked semiconductor device presents various challenges adversely affecting device performance.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides methods of manufacturing stacked semiconductor devices using a dummy channel stack which prevents substrate patterning to avoid formation of a source/drain region at a lower stack inside a substrate, thereby preventing or reducing current leakage from the source/drain region into the substrate. The methods may also use a barrier layer to further prevent or reduce current leakage from the source/drain region into the substrate. The disclosure also provides the stacked semiconductor devices manufactured through these methods.

According to an aspect of the disclosure, there is provided a stacked semiconductor device which may include: a substrate; a 1^{st} source/drain region on the substrate; and a 2^{nd} source/drain region vertically above the 1^{st} source/drain region, the 2^{nd} source/drain region vertically overlapping a 1^{st} portion, among the 1^{st} portion and a 2^{nd} portion, of the 1^{st} source/drain region, wherein a 1^{st} portion of a top surface of the substrate vertically below the 1^{st} portion of the 1^{st} source/drain region and a 2^{nd} portion of the top surface of the substrate vertically below the 2^{nd} portion of the 1^{st} source/drain region are coplanar or aligned.

According to an aspect of the disclosure, there is provided a stacked semiconductor device which may include: a substrate; a 1^{st} source/drain region on the substrate; a 2^{nd} source/drain region vertically above the 1^{st} source/drain region, the 2^{nd} source/drain region vertically overlapping a 1^{st} portion, among the 1^{st} portion and a 2^{nd} portion, of the 1^{st} source/drain region; and a barrier layer on a 2^{nd} portion, among a 1^{st} portion and the 2^{nd} portion, of a top surface of the substrate vertically below the 2^{nd} portion of the 1^{st} source/drain region.

According to an aspect of the disclosure, there is provided a method of manufacturing a stacked semiconductor device, which may include: forming a 1^{st} source/drain region on a substrate; and forming a 2^{nd} source/drain region vertically above the 1^{st} source/drain region, wherein the forming the 1^{st} source/drain region and the 2^{nd} source/drain region is performed such that: the 2^{nd} source/drain region vertically overlaps a 1^{st} portion, among the 1^{st} portion and a 2^{nd} portion, of the 1^{st} source/drain region; and a 1^{st} portion of a top surface of the substrate vertically below the 1^{st} portion of the 1^{st} source/drain region and a 2^{nd} portion of the top surface of the substrate vertically below the 2^{nd} portion of the 1^{st} source/drain region are coplanar or aligned.

According to an aspect of the disclosure, the forming the 1^{st} source/drain region and the 2^{nd} source/drain region may include: forming a 1^{st} channel stack and a 2^{nd} channel stack above the 1^{st} channel stack such that the 2^{nd} channel stack vertically overlaps a 1^{st} portion, among the 1^{st} portion and a 2^{nd} portion, of the 1^{st} channel stack; patterning the 2^{nd} channel stack and the 2^{nd} portion of the 1^{st} channel stack to form a 1^{st} space vertically above the 1^{st} portion of the 1^{st} source/drain region and expose the 2^{nd} potion of the top surface of the substrate; forming a dummy channel stack on the 2^{nd} portion of the top surface of the substrate; and patterning the 1^{st} channel stack and the dummy channel stack to form a 2^{nd} space and expose the 1^{st} portion and the 2^{nd} portion of the top surface of the substrate, wherein the 1^{st} source/drain region is formed in the 2^{nd} space and the 2^{nd} source/drain region is formed in the 1^{st} space.

According to an aspect of the disclosure, there is provided a method of manufacturing a stacked semiconductor device, which may include: forming a barrier layer on a 2^{nd} portion, among a 1^{st} portion and the 2^{nd} portion, of a top surface of a substrate; forming a 1^{st} source/drain region on the 1^{st} portion and the 2^{nd} portion of the top surface of the substrate with the barrier layer thereon; and forming a 2^{nd} source/drain region vertically above the 1^{st} source/drain region, wherein the forming the 1^{st} source/drain region and the 2^{nd} source/drain region is performed such that the 2^{nd} source/drain region vertically overlaps a 1^{st} portion, among the 1^{st} portion and a 2^{nd} portion, of the 1^{st} source/drain region.

### BRIEF DESCRIPTION OF DRAWINGS

Example embodiments of the disclosure will be more clearly understood from the following detailed description taken in conjunction with the accompanying drawings.

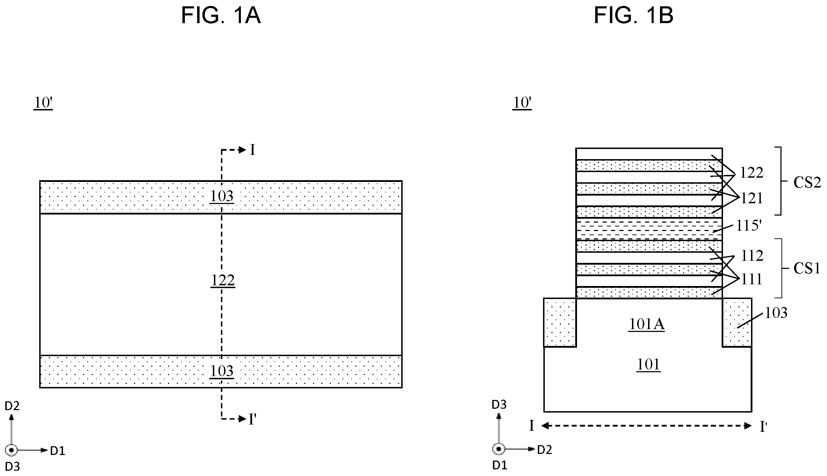

FIGS. 1A-1B through 9A-9B illustrate intermediate semiconductor devices obtained after respective steps of manufacturing a stacked semiconductor device in which a 1^{st} field-effect transistor (FET) at a 1^{st} level and a 2^{nd} FET at a 2^{nd} level above the 1^{st} level have different-width channel structures and different-width source/drain regions, according to one or more embodiments.
FIGS. 1A-9A are plan views of intermediate semiconductor devices 10', and FIGS. 1B-9B are cross-section views of the intermediate semiconductor devices 10' of FIGS. 1A-9A taken along a line I-I' and/or a line II-II' shown therein, respectively.
FIGS. 10A-10B through 17A-17B illustrate intermediate semiconductor devices obtained after respective steps of manufacturing a stacked semiconductor device using a dummy channel stack, according to one or more embodiments.

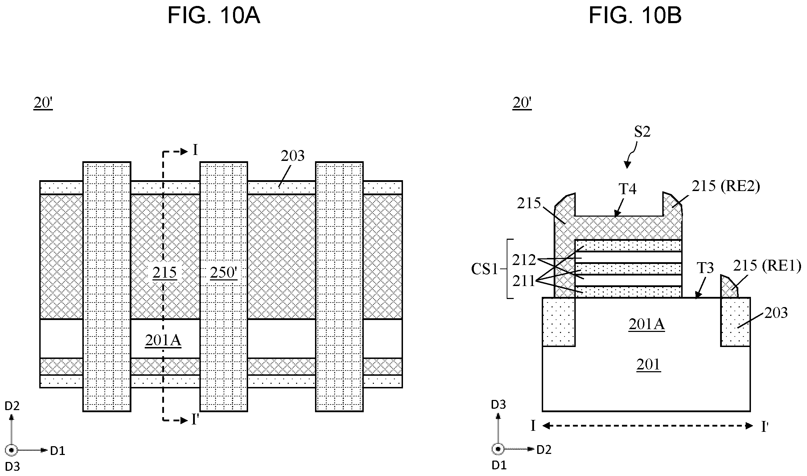

FIGS. 10A-17A are plan views of intermediate semiconductor devices 20', and FIGS. 10B-17B are cross-section views of the intermediate semiconductor devices 20' of FIGS. 10A-17A taken along a line I-I' and/or a line II-II' shown therein, respectively.

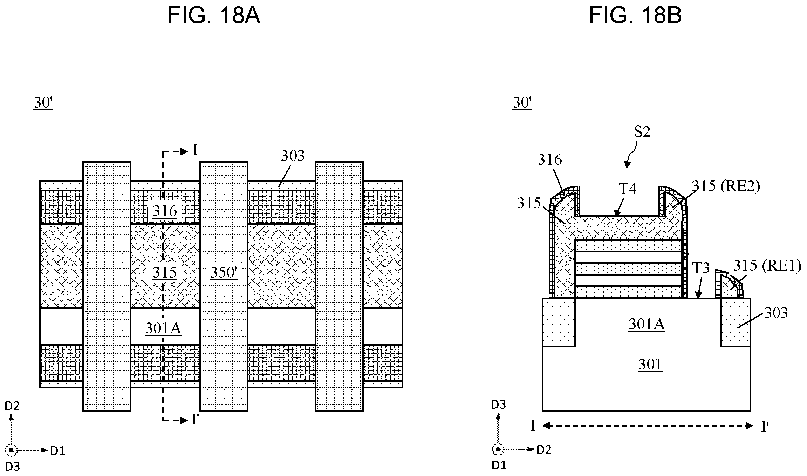

FIGS. 18A-18B through 24A-24B illustrate intermediate semiconductor devices obtained after respective steps of manufacturing a stacked semiconductor device using a dummy channel stack and a barrier layer, according to one or more embodiments.
FIGS. 18A-24A are plan views of intermediate semiconductor devices 20', and FIGS. 18B-24B are cross-section views of the intermediate semiconductor devices 20' of FIGS. 18A-24A taken along a line I-I' and/or a line II-II' shown therein, respectively.

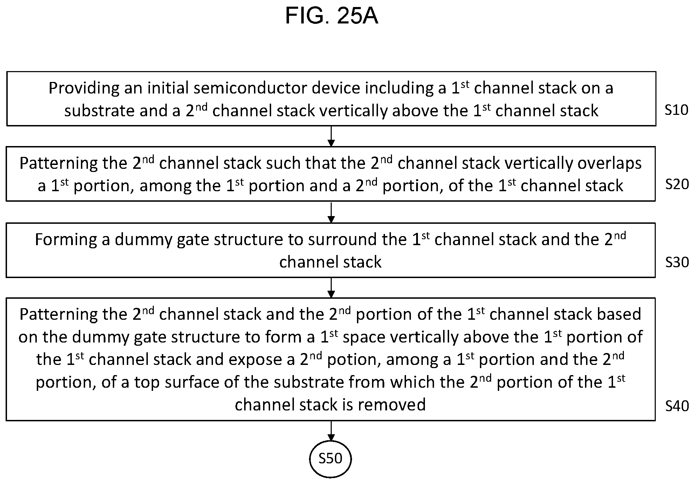

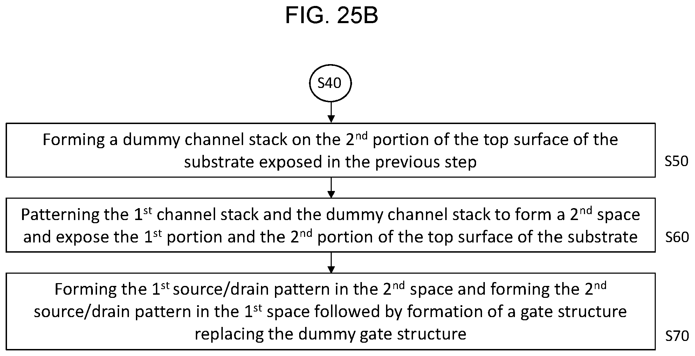

FIGS. 25A and 25B illustrate a flowchart of manufacturing a stacked semiconductor device using a dummy channel stack and a barrier layer, according to one or more embodiments.

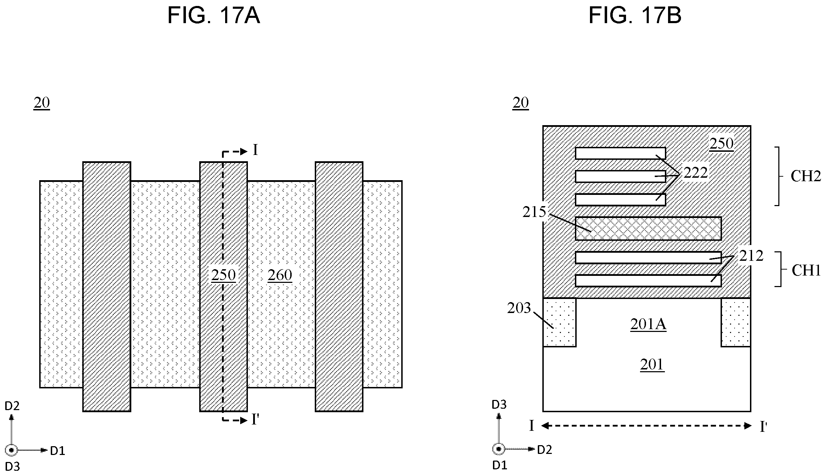

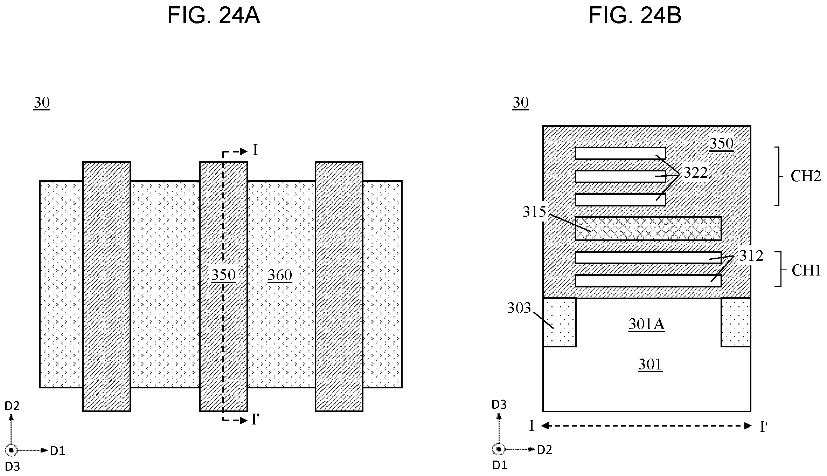

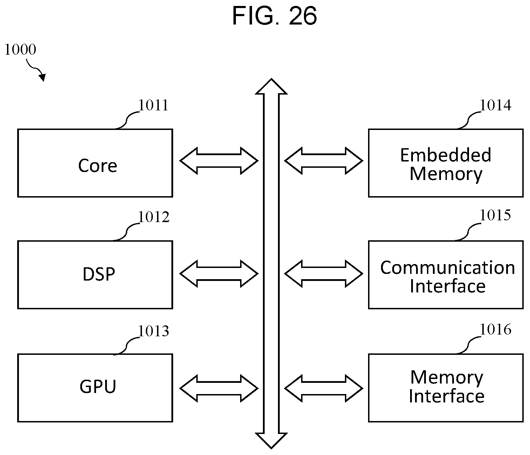

FIG. 26 is a schematic block diagram illustrating an electronic device including one or more stacked semiconductor devices shown in FIGS. 17A-17B and 24A-24B, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, elements referred to as a "left" element and a "right" element" may be a "right" element and a "left" element when a device or structure including these elements are differently oriented. Thus, herein, a "left" element and a "right" element of a structure may also be referred to as a "1^{st}" element and a "2^{nd}" element, respectively, of the structure as long as their structural relationship is clearly understood in the context of the descriptions.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiments could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c.

In the descriptions herein, the terms of degree including "substantially" or "about" may be used. In one or more examples, when specifying that a parameter X may be substantially the same as parameter Y, the term "substantially" may be understood as X being within 10% of Y. In one or more examples, when specifying that a parameter is about X, the term "about" may be understood as being within 10% of X. Still, when a term "same" is used to compare parameters of two or more elements, the term may cover "substantially same" parameters.

It will be understood that, when the term "contact" is used to describe two metal elements, for example, a metal line and a via structure, a barrier metal layer such as titanium (Ti), tantalum (Ta), titanium nitride (TiN), tantalum nitride (TaN), tungsten nitride (WN), nickel nitride (NiN), cobalt nitride (CoN), or platinum nitride (PtN), not being limited thereto, may be formed therebetween. Further, it will be understood that, when a metal contact structure is described as being formed on or contact a surface of a source/drain region, a silicide layer such as cobalt silicide (CoSi₂), nickel silicide (NiSi₂), titanium silicide (TiSi₂), or tungsten silicide (WSi₂), not being limited thereto, may be formed therebetween.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

FIGS. 1A-1B through 9A-9B illustrate intermediate semiconductor devices obtained after respective steps of manufacturing a stacked semiconductor device in which a 1^{st} field-effect transistor (FET) at a 1^{st} level and a 2^{nd} FET at a 2^{nd} level above the 1^{st} level have different-width channel structures and different-width source/drain regions, according to one or more embodiments.

FIGS. 1A-9A are plan views of intermediate semiconductor devices 10', and FIGS. 1B-9B are cross-section views of the intermediate semiconductor devices 10' of FIGS. 1A-9A taken along a line I-I' and/or a line II-II' shown therein, respectively.

Referring to FIGS. 1A and 1B, an intermediate semiconductor device 10' may be formed by epitaxially growing a plurality of semiconductor layers (nanosheet layers) on a substrate 101.

The semiconductor layers, referred to as nanosheet layers, may be epitaxially grown in a D3 direction from an active pattern 101A formed in an upper portion of the substrate 101 in the order of a 1^{st} channel stack CS1 including 1^{st} sacrificial layers 111 and 1^{st} channel layers 112 vertically stacked in an alternating manner, a middle sacrificial layer 115', and a 2^{nd} channel stack CS2 including 2^{nd} sacrificial layers 121 and 2^{nd} channel layers 122 vertically stacked in an alternating manner on the middle sacrificial layer 215'. While the substrate 101 including the active pattern 101A may be formed of silicon (Si), silicon germanium (SiGe), silicon carbide (SiC), etc. or a combination thereof, the active pattern 201A may be doped with impurities to facilitate the epitaxial growth of the semiconductor layers.

The epitaxy of the semiconductor layers may be performed such that the channel layers 112 and 122 are formed of silicon (Si) and the sacrificial layers 111, 115' and 121 are formed of silicon germanium (SiGe) with respective Ge concentrations therein. The middle sacrificial layer 115' may have a higher Ge concentration than the 1^{st} sacrificial layers 111 and the 2^{nd} sacrificial layers 121. For example, the middle sacrificial layer 115' may have a Ge concentration of 40-45%, and the 1^{st} sacrificial layers 111 and the 2^{nd} sacrificial layers 121 may have a Ge concentration of 25-30%.

Here, the sacrificial layers 111, 115' and 121 are referred to as such because these layers will be removed and replaced by other layers or structures in later steps of manufacturing a stacked semiconductor device from the intermediate semiconductor device 10'.

Prior to the formation of the 1^{st} channel stack CS1 and the 2^{nd} channel stack CS2 on the active pattern 101A, shallow trenches extending along a D1 direction may be formed at an upper-left portion and an upper-right portion of the substrate 101 through, for example, dry etching (e.g., reactive ion etching (RIE). The shallow trenches may be filled with a low-k dielectric material such as silicon oxide (e.g., SiO₂) or silicon nitride (SiN, Si₃N₄, etc.), not being limited thereto, to form shallow trench isolation (STI) structures 103 therein. The active pattern 101A may be formed between the STI structures along a D2 direction.

Herein, the D1 direction refers to a channel-length direction in which a current flows between two source/drain regions connected to each other through a channel structure, the D2 direction is a channel-width direction or a cell-height direction, and the D3 direction is a channel-thickness direction. The D1 direction and the D2 direction may each be referred to as a horizontal direction and the D3 direction may be referred to as a vertical direction.

The formation of the STI structures 103 in this step may be performed through, for example, chemical vapor deposition (CVD), not being limited thereto. The STI structures 103 may isolate the active pattern 101A from adjacent active patterns or other circuit elements.

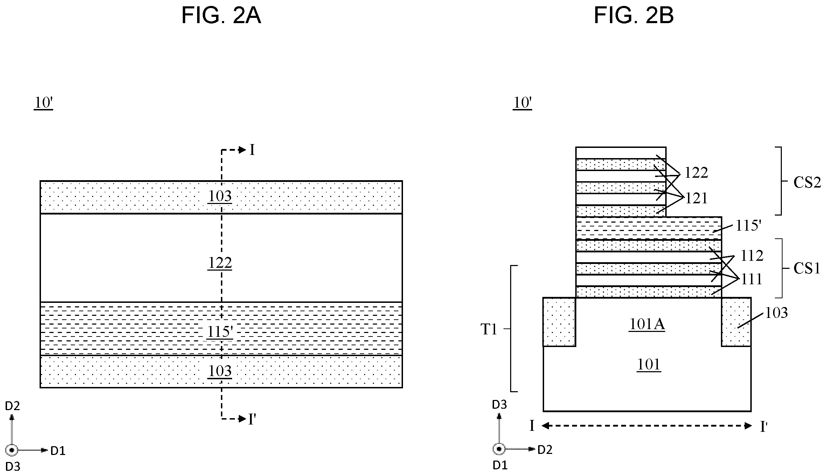

Referring to FIGS. 2A and 2B, the intermediate semiconductor device 10' may be patterned such that the 2^{nd} channel stack CS2 has a smaller width than the 1^{st} channel stack CS1 with a middle sacrificial layer 115' thereon.

The patterning operation in this step may be performed through, for example, dry etching such that the 1^{st} channel stack CS1 including the 1^{st} sacrificial layers 111 and the 1^{st} channel layers 112 is partially overlapped by the 2^{nd} channel stack CS2 including the 2^{nd} sacrificial layers 121 and the 2^{nd} channel layers 122 along the D3 direction. Further, the patterning operation may be performed such that left side surfaces of the 1^{st} channel stack CS1, the middle sacrificial layer 115', and the 2^{nd} channel stack CS2 are vertically aligned or coplanar while a right side surface of the 2^{nd} channel stack CS2 overlaps or meets a top surface of the middle sacrificial layer 115' with the 1^{st} channel stack CS1 therebelow. Thus, the 2^{nd} channel stack CS2 may have a smaller width than the 1^{st} channel stack CS1 and the middle sacrificial layer 115' thereon along the D2 direction. For example, the 2^{nd} sacrificial layers 121 and the 2^{nd} channel layers 122 may have smaller widths than the 1^{st} sacrificial layers 111 and the 1^{st} channel layers 112, respectively, along the D2 direction.

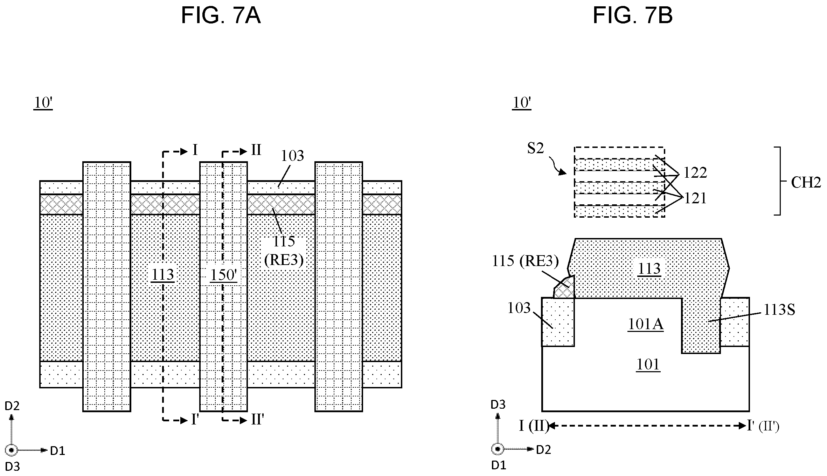

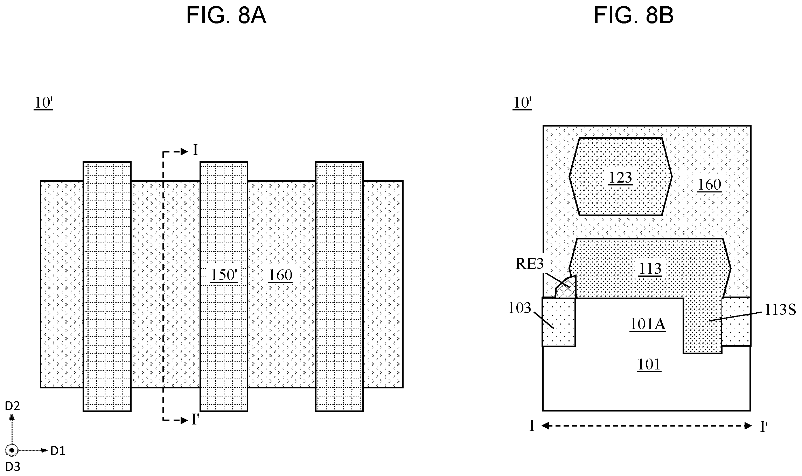

As will be described later, forming the 2^{nd} channel stack CS2 to have a smaller width than the 1^{st} channel stack CS1 in this step is intended to form a 2^{nd} source/drain region to be formed from the 2^{nd} channel layers 122 of the 2^{nd} channel stack CS2 to have a smaller width than a 1^{st} source/drain region to be formed from the 1^{st} channel layers 112 of the 1^{st} channel stack CS1 in later steps (FIGS. 7A-7B and 8A-8B), thereby to facilitate formation of a source/drain contact structure on a top surface of the 1^{st} source/drain region.

Instead, the 2^{nd} channel stack CS2 may be formed to have a greater number of channel layers than the 1^{st} channel stack CS1 so that the 2^{nd} channel layers 122 may have the same or substantially same effective channel width (W_{eff}) as the 1^{st} channel layers 112, and further, the 2^{nd} source/drain region to be formed from the 2^{nd} channel layers 122 may have the same or substantially same volume as the 1^{st} source/drain region to be formed from the 1^{st} channel layers 112.

By patterning the 1^{st} and 2^{nd} channel stacks CS1 and CS2 in this manner, a stacked semiconductor device to be manufactured from the intermediate semiconductor device 10' may achieve optimal device performance depending on a functional type of the stacked semiconductor.

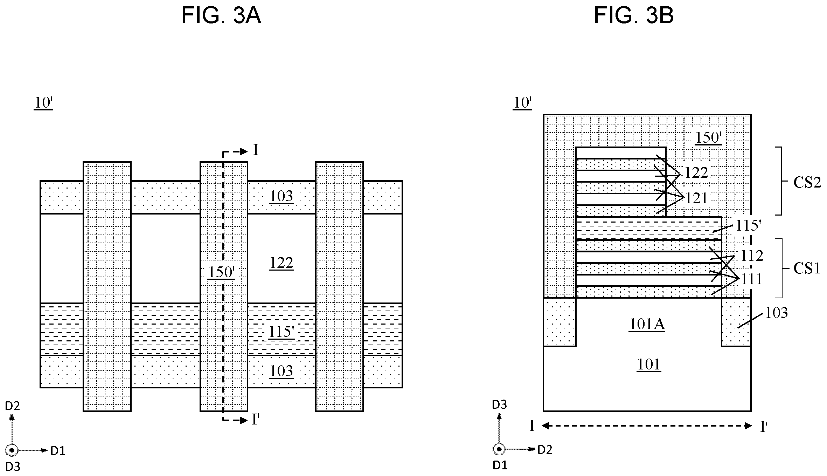

Referring to FIGS. 3A and 3B, a plurality of dummy gate structures 150' may be formed to surround the intermediate semiconductor device 10' obtained in the previous step.

As shown in FIG. 3B, a dummy gate structure 150' may surround the 1^{st} and 2^{nd} channel stacks CS1 and CS2 with the middle sacrificial layer 115' therebetween. The dummy gate structures 150' may be formed through, for example, depositing polysilicon (p-Si) or amorphous silicon (a-Si) on the channel stacks CS1 and CS2 with the middle sacrificial layer 115' therebetween through, for example, physical vapor deposition (PVD), chemical vapor deposition (CVD), plasma enhanced chemical vapor deposition (PECVD), or a combination thereof, followed by photolithography/masking/etching operations.

The dummy gate structures 150' are each a temporary placeholder to define a region for a gate structure and a channel structure to be surrounded by the gate structure for a later step.

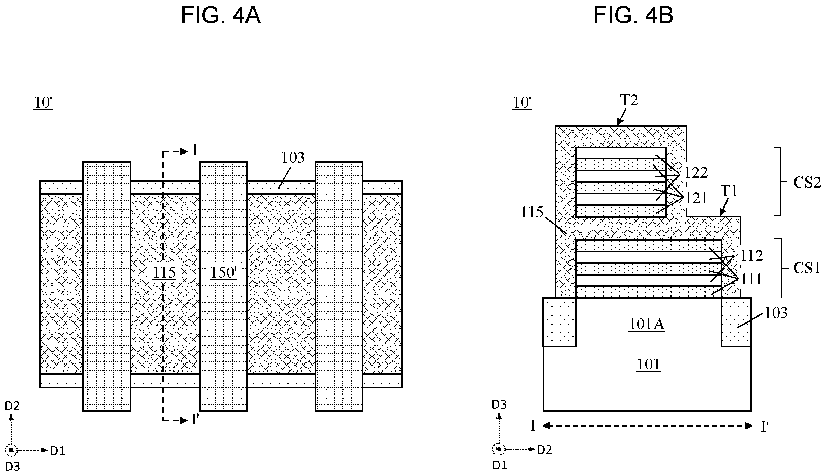

Referring to FIGS 4A and 4B, the middle sacrificial layer 115' may be removed and replaced by a middle isolation layer 115 surrounding the 1^{st} and 2^{nd} channel stacks CS1 and CS2.

The removal of the middle sacrificial layer 115' may be performed through, for example, wet etching using an etchant such as an ammonia-peroxide mixture which removes the middle sacrificial layer 115' of SiGe with a high Ge concentration (40-45%) while the 1^{st} and 2^{nd} channel layers 112 and 122 of silicon (Si) and the 1^{st} and 2^{nd} sacrificial layers 111 and 121 of SiGe with a low Ge concentration (25-30%) are not or minimally attacked by the etchant.

Further, an isolation material such as SiBCN, SiCN, SiOC, SiOCN, SiN, Si₃N₄, etc., may fill in a space from which the middle sacrificial layer 115' is removed, thereby forming a middle isolation layer 115. The formation of the middle isolation layer 115 may be performed through, for example, CVD, ALD or PEALD. At this time, the middle isolation layer 115 may be spread to conformally surround the outer profile of the 1^{st} and 2^{nd} channel stacks CS1 and CS2 as well as top surfaces of the STI structures 103.

The middle isolation layer 115 may be formed to isolate a channel structure to be formed from the 1^{st} channel stack CS1 and a channel structure to be formed from the 2^{nd} channel stack CS2.

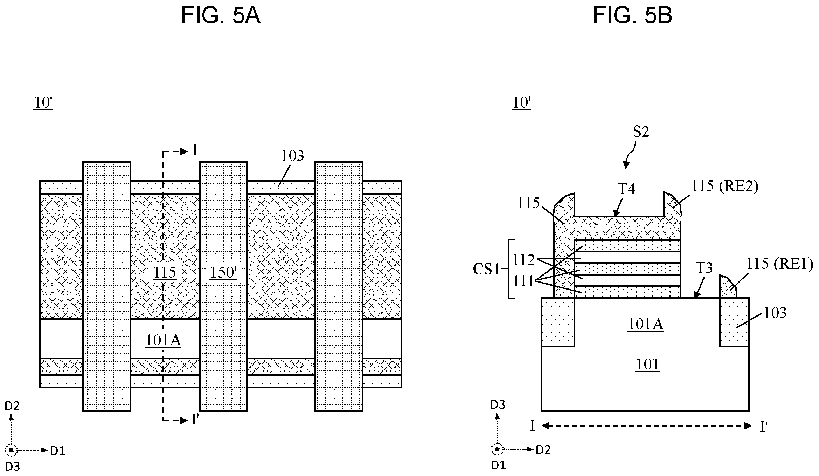

Referring to FIGS. 5A and 5B, the 2^{nd} channel stack CS2 with an upper portion of the middle isolation layer 115 thereon may be patterned based on the dummy gate structures 150' to provide a space S2 where a 2^{nd} source/drain region, which is an upper source/drain region, is to be formed in a later step (FIGS. 8A and 8B).

It is to be understood here that, in this step, the 2^{nd} channel stack CS2 with an upper portion of the middle isolation layer 115 thereon may be removed only between and at sides of the dummy gate structures 150' along the D1 direction as shown in FIG. 5A, and thus, the 2^{nd} channel stack CS2 as well as the 1^{st} channel stack CS1 surrounded by or below the dummy gate structures 150' may not be patterned.

When the 2^{nd} channel stack CS2 with the upper portion of the middle isolation layer 115 thereon is patterned, a right portion of the 1^{st} channel stack CS1 which is not vertically overlapped by the 2^{nd} channel stack CS2 and a lower portion of the middle isolation layer 115 surrounding the right portion of the 1^{st} channel stack CS1 may also be patterned as shown in FIG. 5B. This is because, when the patterning operation is performed along the D3 direction to form the space S2 from a top surface T2 of the upper portion of the middle isolation layer 115 which is exposed upward, a top surface T1 of the lower portion of the middle isolation layer 115 which is also exposed upward may also be subjected to the patterning operation. The patterning operation in this step may be performed through, for example, dry etching (e.g., reactive ion etching), not being limited thereto.

The removal of the right portion of the 1^{st} channel stack CS1 may expose a top surface T3 of a portion of the substrate 101, for example, a top surface of a portion of the active pattern 101A, and a top surface T4 of the lower portion of the middle isolation layer 115. At this time, residues RE2 of the upper portion of the middle isolation layer 115 and a residue RE1 of the lower portion of the middle isolation layer 115 may remain as shown in FIG. 5B due to an etch selectivity or etch rate difference between the 1^{st} and 2^{nd} channel stacks CS1, CS2 and the middle isolation layer 115 and a height difference between the top surfaces T1 and T2 of in the middle isolation layer 115 as shown in FIG. 4B.

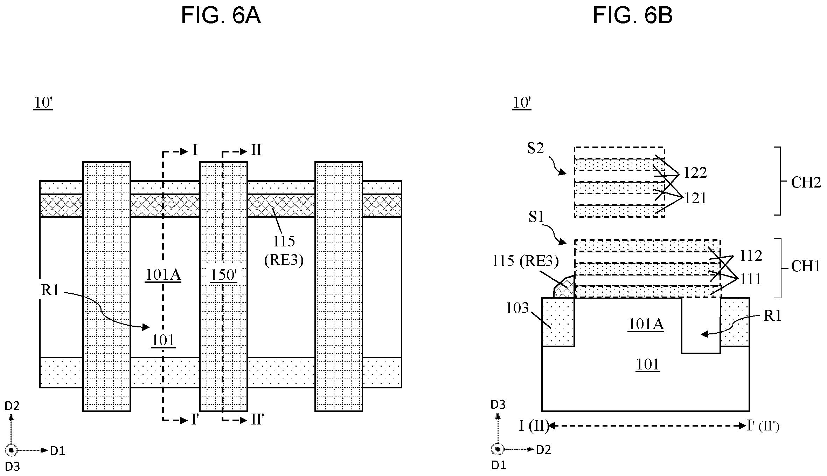

Referring to FIGS. 6A and 6B, the 1^{st} channel stack CS1 with the lower portion of the middle isolation layer 115 thereon may be patterned to provide a space S1 where a 1^{st} source/drain region, which is a lower source/drain region, is to be formed in a later step (FIGS. 7A and 7B).

It is to be understood here that, in this step, the 1^{st} channel stack CS1 with the lower portion of the middle isolation layer 115 thereon may be removed only between and at sides of the dummy gate structures 150' along the D1 direction as shown in FIG. 6A, and thus, the 1^{st} channel stack CS1 as well as the 2^{nd} channel stack CS2 surrounded by or below the dummy gate structures 150' may not be patterned. Thus, these portions of the 1^{st} channel stack CS1 and the 2^{nd} channel stack CS2 surrounded by or below the dummy gate structures 150' may form a 1^{st} channel structure CH1 and a 2^{nd} channel structure CH2 thereabove surrounded by or below each of the dummy gate structures 150'. These two channel structures CH1 and CH2 may be shown in dashed lines in FIG. 6B which shows a cross-section view along a line II-II' of FIG. 6A.

In the meantime, when the 1^{st} channel stack CS1 is removed to form the space S1, a portion of the substrate 101, for example, a right portion of the active pattern 101A exposed in the previous step, may also be removed to form a recess R1 in the substrate 101, for example, the active pattern 101A. This is because, when the patterning operation is performed along the D3 direction to form the space S1 from the top surface T4 of the lower portion of the middle isolation layer 115 which is exposed upward, the top surface T3 of the substrate 101 which is also exposed upward may also be subjected to this patterning operation.

At this time when the 1^{st} channel stack CS1 is removed, the residues RE1 and RE2 of the middle isolation layer 115 may also be removed. However, the middle isolation layer 150 remaining on a left side surface of the 1^{st} channel stack CS1 may not be patterned entirely, and instead, a lower portion thereof may remain as a residue RE3 due to an etch selectivity or etch rate difference between the 1^{st} channel stack CS1 and the middle isolation layer 115 and a height difference between portions of the middle isolation layer 115 as shown in FIG. 5B.

Referring to FIGS. 7A and 7B, 1^{st} source/drain regions 113 may be formed from the 1^{st} channel structure CH1 including the 1^{st} channel layers 112 in the space S1 obtained by patterning the 1^{st} channel stack CS1 in the previous step (FIGS. 6A and 6B).

The 1^{st} source/drain regions 113 may be epitaxially grown mainly along the D1 direction from the 1^{st} channel layers 112 of the 1^{st} channel structure CH1 surrounded by or below the dummy gate structure 150', while the 1^{st} sacrificial layers 111 of the 1^{st} channel structure CH1 are covered by inner spacers formed at side surfaces thereof. When the epitaxial growth of the 1^{st} source/drain regions 113 is performed, the epitaxial structure forming the 1^{st} source/drain region 113 may be in-situ doped with n-type impurities such as phosphorus (P), arsenic (As), antimony (Sb), etc. or p-type impurities such as boron (B), gallium (Ga), or indium (In), etc.

However, when the 1^{st} source/drain region 113 is epitaxially grown from the 1^{st} channel layers 112 in the intermediate semiconductor device 10' shown in FIGS. 6A and 6B, the epitaxial structure may be overgrown to form a portion 113S of the 1^{st} source/drain region 113 in the recess R1 in the upper portion of the substrate 101, for example, in the right portion of the active pattern 101A, as shown in FIG. 7B. When the portion 113S of the 1^{st} source/drain region 113 with the impurities therein is formed inside the substrate 101, for example, the active pattern 110A, current leakage from the 1^{st} source/drain region 113 into the substrate 101 including the active pattern 101A may occur or increase when a stacked semiconductor device manufactured from the intermediate semiconductor device 10' is powered on. Such current leakage will be a cause of performance degradation of the stacked semiconductor device.

Referring to FIGS. 8A and 8B, 2^{nd} source/drain regions 123 may be formed from the 2^{nd} channel structure CH2 including the 2^{nd} channel layers 122 in the space S2 obtained by patterning the 2^{nd} channel stack CS2 in the previous step (FIGS. 5A and 5B).

The 2^{nd} source/drain regions 123 may be epitaxially grown mainly along the D1 direction from the 2^{nd} channel layers 122 of the 2^{nd} channel structure CH2 surrounded by or below the dummy gate structure 150', while the 2^{nd} sacrificial layers 121 of the 2^{nd} channel structure CH2 are covered by inner spacers formed at side surfaces thereof. When the epitaxial growth of the 2^{nd} source/drain regions 123 is performed, the epitaxial structure forming the 2^{nd} source/drain region 123 may be in-situ doped with p-type impurities such as boron (B), gallium (Ga), or indium (In), etc. or n-type impurities such as phosphorus (P), arsenic (As), antimony (Sb), etc.

With the formation of the 1^{st} and 2^{nd} source/drain regions 113 and 123, an isolation structure 160 may be formed to surround the 1^{st} and 2^{nd} source/drain regions 113 and 123 to isolate the 1^{st} and 2^{nd} source/drain regions 113 and 123 from each other or other circuit elements. The isolation structure 160 may be formed through, for example, deposition of a low-k material such as silicon oxide (e.g. SiO₂) using CVD, PVD, PECVD, etc.

As described earlier, the 2^{nd} source/drain region 123 grown from the 2^{nd} channel layers 122 may have a smaller width than the 1^{st} source/drain region 113 grown from the 1^{st} channel layers 112 because of the channel-width difference. Further, the 2^{nd} source/drain region 123 may only partially overlap the 1^{st} source/drain region 113 in the D3 direction. For example, a right portion of the 1^{st} source/drain region 113 may not be overlapped by the 2^{nd} source/drain region 123 such that left side surface of the two source/drain region 113 and 123 are aligned or coplanar with each other in the D3 direction while right side surfaces thereof are not. With this width difference between the two source/drain regions 113 and 123, a stacked semiconductor device to be completed from the intermediate semiconductor device 10' may facilitate formation of a source/drain contact structure on a top surface of the 1^{st} source/drain region 113 which is not overlapped by the 2^{nd} source/drain region 123 and achieve optimal device performance depending on a functional type of the stacked semiconductor device.

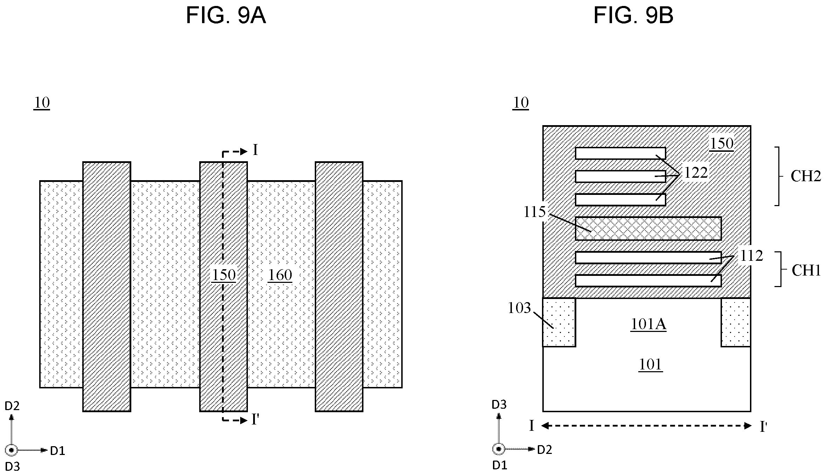

Referring to FIGS. 9A and 9B, the dummy gate structures 150' and the 1^{st} and 2^{nd} sacrificial layers 111 and 121 respectively included in the 1^{st} and 2^{nd} channel structures CH1 and CH2 may be replaced by gate structures 150 to form a stacked semiconductor device 10.

The dummy gate structures 150' and the 1^{st} and 2^{nd} sacrificial layers 111 and 121 may be removed through, for example, wet etching, not being limited thereto, to release the 1^{st} channel layers 112 and the 2^{nd} channel layers 122 from the 1^{st} sacrificial layers 111 and the 2^{nd} sacrificial layers 121. Further, a space provided by the removal of the dummy gate structures 150' and the 1^{st} and 2^{nd} sacrificial layers 111 and 121 may be filled in with a metal or metal alloy to form the gate structures 150 through, for example, atomic layer deposition (ALD), plasma-enhanced ALD (PEALD), CVD, PVD, etc. or a combination thereof, not being limited thereto.

Thus, a gate structure 150, the 1^{st} channel structure CH1 including the 1^{st} channel layers 112 and the 1^{st} source/drain regions 113 may form a 1^{st} FET at the 1^{st} level of the stacked semiconductor device 10, and the gate structure 150, the 2^{nd} channel structure CH2 including the 2^{nd} channel layers 122 and the 2^{nd} source/drain regions 123 may form a 2^{nd} FET at the 2^{nd} level of the stacked semiconductor device 10.

However, referring back to FIGS. 7A and 7B, due to the portion 113S of the 1^{st} source/drain region 113 formed in the recess R1 may adversely affect the performance of the stacked semiconductor device 10 by leaking current into the substrate 101. For example, in a case in which the 1^{st} FET of the stacked semiconductor device 10 is of n-type to form a pull-down transistor or a pass-gate transistor of a static-random-access memory (SRAM), the current leakage from the 1^{st} source/drain regions 113 into the substrate 101 may slow read/write speed of the SRAM.

The following embodiments are provided to address the current leakage from the 1^{st} source/drain regions 113 formed in the substrate 101 as described above.

FIGS. 10A-10B through 17A-17B illustrate intermediate semiconductor devices obtained after respective steps of manufacturing a stacked semiconductor device using a dummy channel stack, according to one or more embodiments.

FIGS. 10A-17A are plan views of intermediate semiconductor devices 20', and FIGS. 10B-17B are cross-section views of the intermediate semiconductor devices 20' of FIGS. 10A-17A taken along a line I-I' and/or a line II-II' shown therein, respectively.

Referring to FIGS. 10A and 10B, an intermediate semiconductor device 20' obtained in this step may be the same as or similar to the intermediate semiconductor device 10' shown in FIGS. 5A and 5B, and thus, descriptions of respective steps to obtain the intermediate semiconductor device 20' shown in FIGS. 10A and 10B may be omitted herein for brevity purposes.

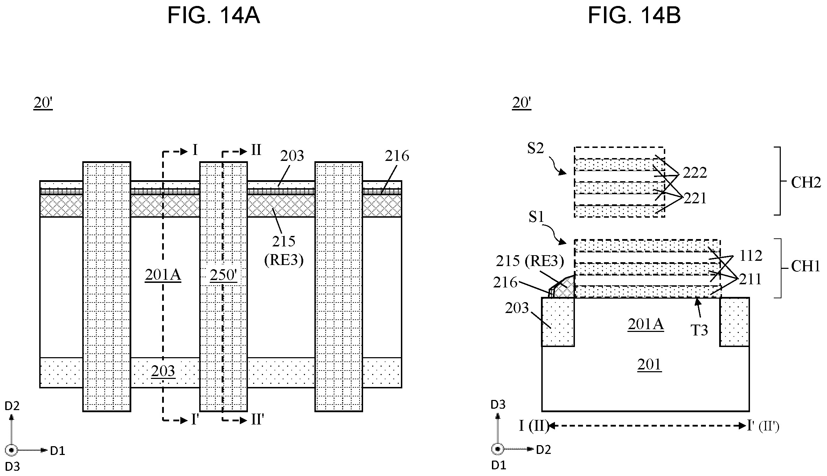

The intermediate semiconductor device 20' may include a 1^{st} channel stack CS1 formed on an active pattern 201A of a substrate 201 with STI structures 203 at sides thereof and a 2^{nd} channel stack CS2 (FIG. 14B) formed above the 1^{st} channel stack CS1. The 1^{st} channel stack CS1 may include 1^{st} sacrificial layers 211 and 1^{st} channel layers 212, and the 2^{nd} channel stack CS2 may include 2^{nd} sacrificial layers 221 and 2^{nd} channel layers 222. The intermediate semiconductor device 20' may also include dummy gate structures 250' and a patterned middle isolation layer 215 including residues RE1 and RE2.

In addition, in the intermediate semiconductor device 20' of this step may be formed a space S2 obtained by removing the 2^{nd} channel stack CS2 with an upper portion of the middle isolation layer 215. Further, in the intermediate semiconductor device 20' of this step, a right portion of the 1^{st} channel stack CS1 with a lower portion of the middle isolation layer 215 thereon may be removed to expose a top surface T3 of the active pattern 201A and a top surface T4 of the patterned middle isolation layer 215.

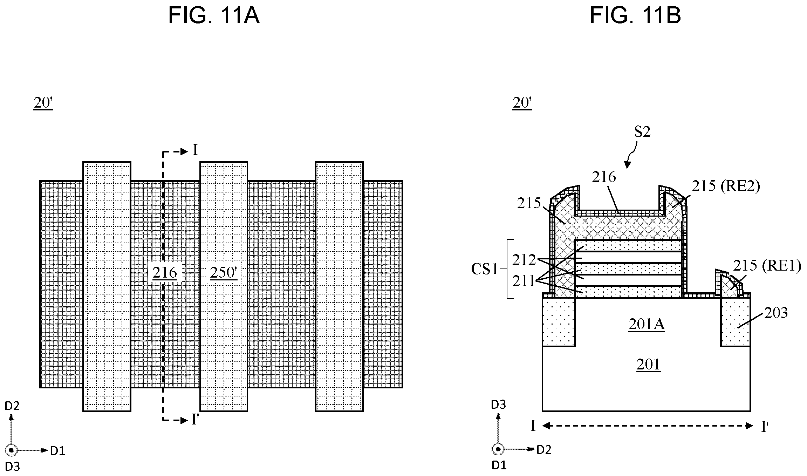

Referring to FIGS. 11A and 11B, a protection layer 216 may be formed on a top surface of the intermediate semiconductor device 20', except the dummy gate structures 250', obtained in the previous step.

The protection layer 216 may be formed through, for example, depositing an isolation material such as silicon nitride (e.g., SiN or Si₃N₄) by atomic layer deposition (ALD), plasma-enhanced ALD (PEALD), etc. or a combination thereof, not being limited thereto, on the top surface T4 of the middle isolation layer 215, the top surface T3 of the active pattern 201A and top surfaces of the STI structures 203 exposed upward between the dummy gate structures 250'.

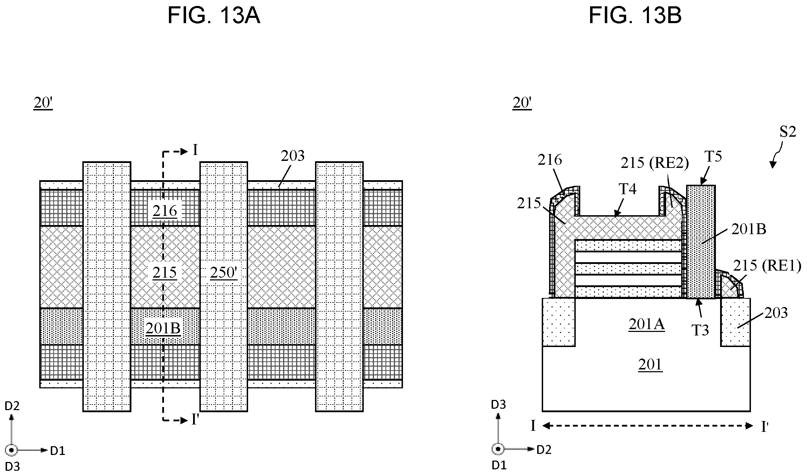

The protection layer 216 may be used to protect the middle isolation layer 215 and the STI structures 203 from an epitaxy process to be performed in a later step (FIGS. 13A and 13B).

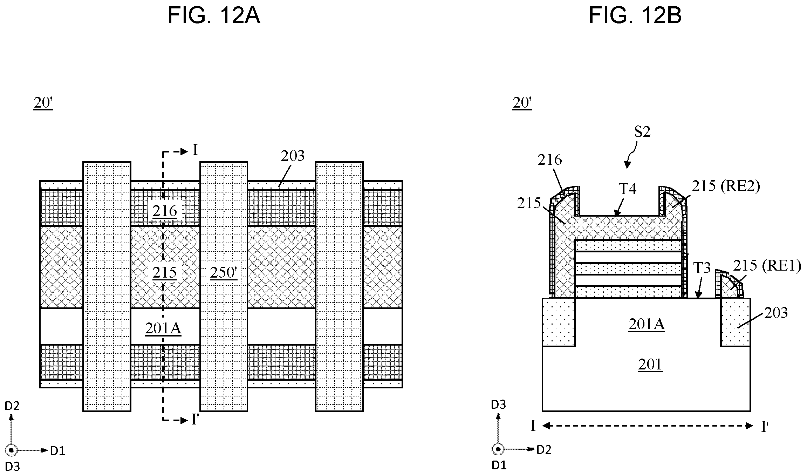

Referring to FIGS. 12A and 12B, the protection layer 216 formed on the top surface T3 of the active pattern 201A may be removed to expose this portion of the top surface of the active pattern 201A upward.

The selective removal of the protection layer 216 in this step may be performed through, for example, dry etching, ashing, stripping, etc., not being limited thereto, to expose the top surface T3 of the active pattern 201A so that an epitaxy process may be performed on the exposed top surface T3 of the active pattern 201A in a next step (FIGS. 13A and 13B). At this time, the selective removal operation may also remove the protection layer 216 formed on the top surface of the STI structures 203 as well as the top surface T4 of the middle isolation layer 215 except the residues RE1 and RE2.

Referring to FIGS. 13A and 13B, a dummy channel stack 201B may be grown from the top surface T3 of the active pattern 201A of the substrate 101 such that a top surface T5 of the dummy channel stack 201B is at a level of or higher than the top surface T4 of the patterned middle isolation layer 215.

The dummy channel stack 201B may be an epitaxial structure grown from the active pattern 201A at a lateral side of the 1^{st} channel stack CS1. The dummy channel stack 201B may be formed to prevent the active pattern 201A from being patterned when the 1^{st} channel stack CS1 with the upper portion of the middle isolation layer 215 and the protection layer 216 thereon is patterned to form a space S1 for a 1^{st} source/drain region 113 in a next step. With the dummy channel stack 201B formed on the active pattern 201A, the dummy channel stack 201B, instead of the active pattern 201A, may be patterned along with the 1^{st} channel stack CS1 with the upper portion of the middle isolation layer 215 and the protection layer 216 thereon. Thus, the active pattern 201A below the dummy channel stack 201B may not be etched to form a recess therein such as the recess R1 shown in FIGS. 6A and 6B.

To serve this purpose, the dummy channel stack 201B may be grown from the top surface T3 of the active pattern 201A to have a height similar or corresponding to a height of the 1^{st} channel stack CS1 with the patterned middle isolation layer 215 and the protection layer 216 thereon by controlling an amount of epitaxy elements, epitaxy temperature and/or a time duration of the epitaxy. For example, the dummy channel stack 201B may be grown such that the top surface T5 thereof is at the level or higher than the top surface T4 of the patterned middle isolation layer 215, not being limited thereto. Further, the dummy channel stack 201B may be grown to be formed of a material such as Si, SiGe or a combination thereof which is the same as or similar to the materials forming the 1^{st} channel stack CS1 including the 1^{st} channel layers 212 and the 1^{st} sacrificial layers 211. The dummy channel stack 201B may not be doped with impurities.

Referring to FIGS. 14A and 14B, the 1^{st} channel stack CS1 with the lower portion of the middle isolation layer 215 and the protection layer 216 thereon may be patterned along with the dummy channel stack 201B to provide the space S1 where the 1^{st} source/drain region, which is a lower source/drain region, is to be formed in a next step.

It is to be understood that, in this step, the 1^{st} channel stack CS1 with the lower portion of the middle isolation layer 215 and the protection layer 216 thereon may be removed only between and at sides of the dummy gate structures 250' along the D1 direction as shown in FIG. 14A, and thus, the 1^{st} channel stack CS1 as well as the 2^{nd} channel stack CS2 surrounded by or below the dummy gate structures 250' may not be patterned. Thus, these portions of the 1^{st} channel stack CS1 and the 2^{nd} channel stack CS2 surrounded by or below the dummy gate structures 250' may form a 1^{st} channel structure CH1 and a 2^{nd} channel structure CH2 thereabove surrounded by or below each of the dummy gate structures 250'. These two channel structures CH1 and CH2 may be shown in dashed lines in FIG. 14B which shows a cross-section view along a line II-II' of FIG. 14A.

Like the patterning operation performed on the intermediate semiconductor device 10' as shown in FIGS. 6A and 6B, the patterning operation performed on the intermediate semiconductor device 20' in this step may be performed such that the 1^{st} channel layers 212 are entirely exposed along the D1 direction in the space S1 to facilitate epitaxial growth of the 1^{st} source/drain region from the 1^{st} channel layers 212 in the next step. However, unlike in the intermediate semiconductor device 10' of FIGS. 6A and 6B, the patterning operation in this step may not remove a portion of the substrate 201, for example, a right portion of the active pattern 201A to form a recess in the active pattern 201A such as the recess R1 in the active pattern 101A as shown in FIG. 6B. This is because the dummy channel stack 201B formed on the top surface T3 of the active pattern 201A in the previous step may prevent formation of such recess in the active pattern 201A.

Further, the dummy channel stack 201B may be patterned along with the 1^{st} channel stack CS1 with the lower portion of the middle isolation layer 215 and the protection layer 216 thereon at a substantially same etch rate. Thus, when the 1^{st} channel stack CS1 is removed to expose the top surface T3 of the active pattern 201A, the dummy channel stack 201B may also be removed to expose the top surface T3 of the active pattern 201A therebelow.

At this time when the 1^{st} channel stack CS1 is removed, the residues RE1 and RE2 of the middle isolation layer 215 may also be removed. However, the middle isolation layer 215 remaining on a left side surface of the 1^{st} channel stack CS1 may not be patterned entirely, and instead, a lower portion thereof may remain as a residue RE3 due to an etch selectivity or etch rate difference between the 1^{st} channel stack CS1 and the middle isolation layer 215 and a height difference between portions of the middle isolation layer 215 as shown in FIG. 14B. Further, a portion of the protection layer 216 may also remain on a left side surface of this residue RE3 of the middle isolation layer 215 after the 1^{st} channel stack CS1 is patterned.

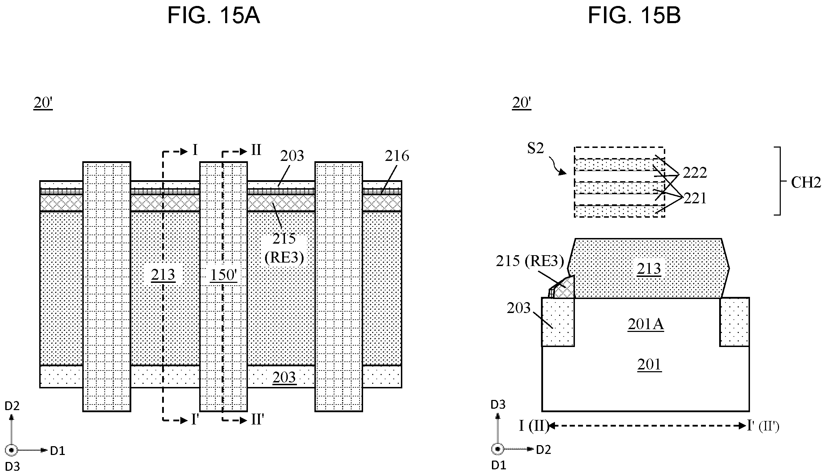

Referring to FIGS. 15A and 15B, 1^{st} source/drain regions 213 may be formed from the 1^{st} channel structure CH1 including the 1^{st} channel layers 212 in the space S1 obtained by patterning the 1^{st} channel stack CS1 in the previous step (FIGS. 14A and 14B).

The 1^{st} source/drain regions 213 may be epitaxially grown mainly along the D1 direction from the 1^{st} channel layers 212 of the 1^{st} channel structure CH1 surrounded by or below the dummy gate structure 250', while the 1^{st} sacrificial layers 211 of the 1^{st} channel structure CH1 are covered by inner spacers formed at side surfaces thereof. When the epitaxial growth of the 1^{st} source/drain regions 213 is performed, the epitaxial structure forming the 1^{st} source/drain region 213 may be in-situ doped with n-type impurities such as phosphorus (P), arsenic (As), antimony (Sb), etc. or p-type impurities such as boron (B), gallium (Ga), or indium (In), etc.

However, unlike in the intermediate semiconductor device 10' shown in FIGS. 7A and 7B, no portion of the 1^{st} source/drain region 213 is formed inside the substrate 201, for example, the active pattern 201A because a recess like the recess R1 formed in the substrate 101 of the intermediate semiconductor device 10' is not formed in the substrate 201 due to the dummy channel stack 201B formed in the previous step (FIGS. 13A and 13B). Thus, current leakage like the current leakage that may be generated from the portion 113S of the 1^{st} source/drain region 113 formed inside the substrate 101 may be prevented or reduced in a stacked semiconductor device manufactured from the intermediate semiconductor device 20'.

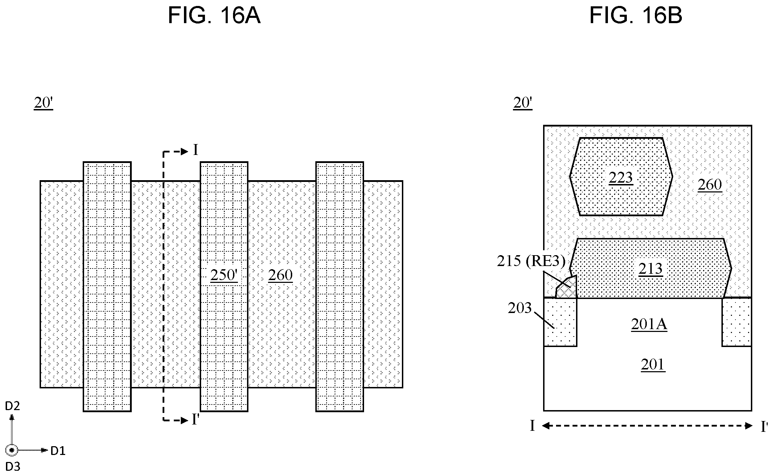

Referring to FIGS. 16A and 16B, 2^{nd} source/drain regions 223 may be formed from the 2^{nd} channel structure CH2 including the 2^{nd} channel layers 222 in the space S2 obtained by patterning the 2^{nd} channel stack CS2 in the previous step (FIGS. 10A and 10B).

The formation of the 2^{nd} source/drain regions 223 may be performed in the same or similar manner applied to the formation of the 2^{nd} source/drain region 123 of the intermediate semiconductor device 10' as shown in FIGS. 8A and 8B, and thus, duplicate descriptions thereof may be omitted herein.

Referring to FIGS. 17A and 17B, the dummy gate structures 250' and the sacrificial layers 211 and 221 respectively included in the channel structures CH1 and CH2 may be replaced by gate structures 250 to form a stacked semiconductor device 20.

The formation of the gate structure 250 may be performed in the same or similar manner applied to the formation of the gate structure 150 of the intermediate semiconductor device 10' as shown in FIGS. 9A and 9B, and thus, duplicate descriptions thereof may be omitted herein.

However, referring back to FIGS. 13A-13B to FIGS. 15A-15B, due to the dummy channel stack 201B grown from the substrate 201, the substrate 201 may not be patterned when the 1^{st} channel stack CS1 is removed, and thus, no portion of the 1^{st} source/drain region 213 may be formed inside the substrate 201, thereby to prevent or reduce current leakage from the 1^{st} source/drain region 213 to the substrate 201. Thus, the stacked semiconductor device 20 may prevent decrease of device performance caused by current leakage.

FIGS. 18A-18B through 24A-24B illustrate intermediate semiconductor devices obtained after respective steps of manufacturing a stacked semiconductor device using a dummy channel stack and a barrier layer, according to one or more embodiments.

FIGS. 18A-24A are plan views of intermediate semiconductor devices 20', and FIGS. 18B-24B are cross-section views of the intermediate semiconductor devices 20' of FIGS. 18A-24A taken along a line I-I' and/or a line II-II' shown therein, respectively.

Referring to FIGS. 18A and 18B, an intermediate semiconductor device 30' obtained in this step may be the same as or similar to the intermediate semiconductor device 20' shown in FIGS. 12A and 12B, and thus, descriptions of respective steps to obtain the intermediate semiconductor device 30' shown in FIGS. 18A and 18B may be omitted herein for brevity purposes.

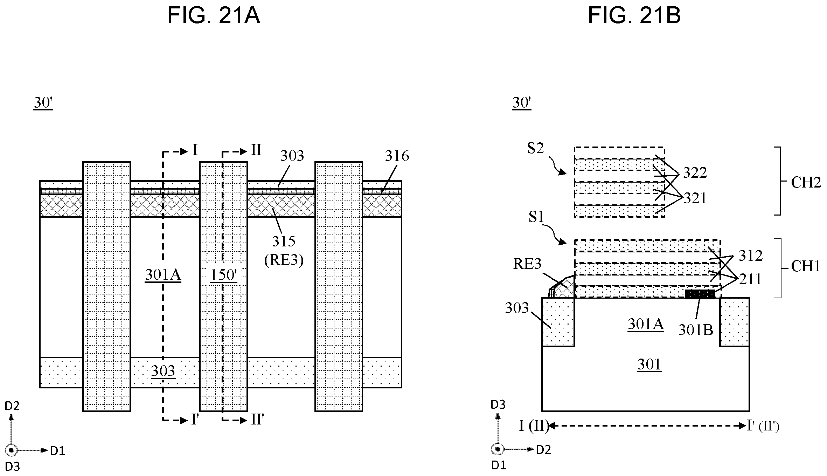

The intermediate semiconductor device 30' may include a 1^{st} channel stack CS1 formed on an active pattern 301A of a substrate 301 with STI structures 303 at sides thereof and a 2^{nd} channel stack CS2 (FIG. 21B) formed above the 1^{st} channel stack CS1. The 1^{st} channel stack CS1 may include 1^{st} sacrificial layers 311 and 1^{st} channel layers 312, and the 2^{nd} channel stack CS2 may include 2^{nd} sacrificial layers 321 and 2^{nd} channel layers 322. The intermediate semiconductor device 30' may also include dummy gate structures 350' and a patterned middle isolation layer 315 including residues RE1 and RE2.

In addition, in the intermediate semiconductor device 30' of this step may be formed a space S2 obtained by removing the 2^{nd} channel stack CS2 with an upper portion of the middle isolation layer 315. Further, in the intermediate semiconductor device 30' of this step, a right portion of the 1^{st} channel stack CS1 with a lower portion of the middle isolation layer 315 thereon may be removed to expose a top surface T3 of the active pattern 301A and a top surface T4 of the patterned middle isolation layer 315. Moreover, a protection layer 316 may be formed on the intermediate semiconductor device 30' in the same manner as the protection layer 216 on the intermediate semiconductor device 20' and patterned as shown in FIGS. 11A-11B and 12A-12B.

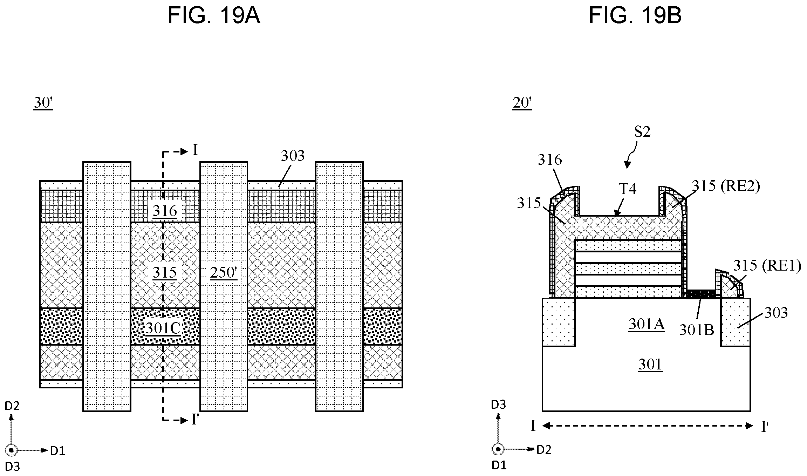

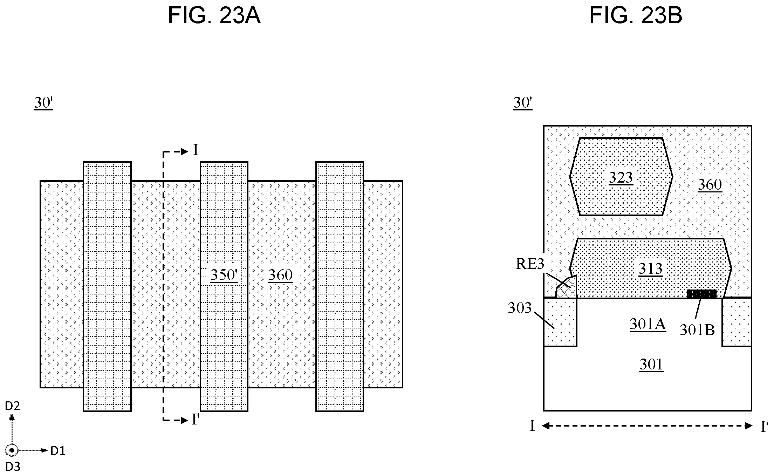

Referring to FIGS. 19A and 19B, a thin barrier layer 301B may be formed on a top surface T3 of the active pattern 301A exposed when the 2^{nd} channel stack CS2 is patterned to form a space S2 (see FIGS. 4A-4B and 5A-5B) where a 2^{nd} source/drain region is to be formed in a later step (FIGS. 23A and 23B).

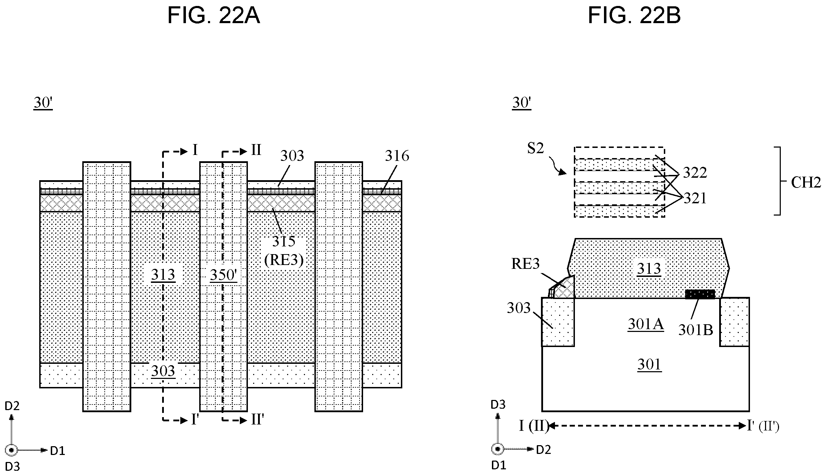

The barrier layer 301B may have a smaller thickness than each of the 1^{st} sacrificial layers 311, for example, not being limited thereto. The barrier layer 301B may be epitaxially grown from the active pattern 301A and in-situ doped with impurities that may be of the same polarity type as a 1^{st} source/drain region to be formed thereon based on the 1^{st} channel layers 312 in a later step (FIGS. 22A and 22B).

However, the in-situ doping in this step may be controlled such that the barrier layer 301B has less concentration of the impurities. For example, when the 1^{st} source/drain region to be formed above the barrier layer 301B in a later step (FIGS. 23A and 23B) is to be on n-type doped with impurities such as phosphorus (P), arsenic (As), antimony (Sb), etc., the barrier layer 301B may be doped with the same n-type impurities with less concentration than in the 1^{st} source/drain region to suppress carrier mobility from the 1^{st} source/drain region into the active pattern 210A of the substrate 201 to improve prevention or reduction of current leakage from the 1^{st} source/drain region to the substrate 201.

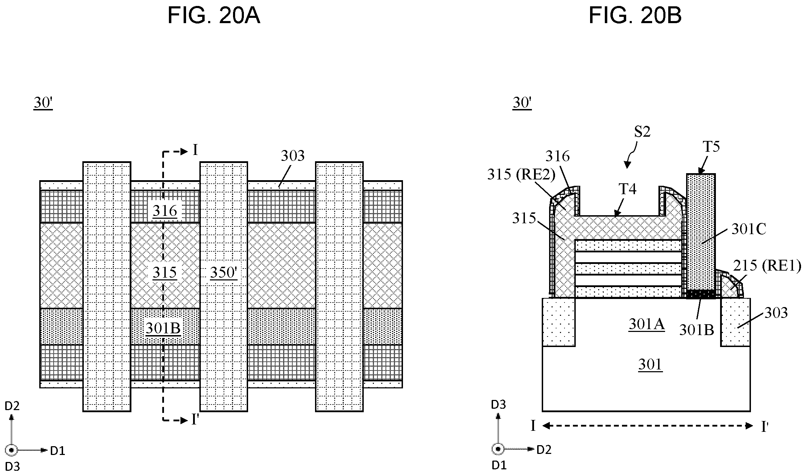

Referring to FIGS. 20A and 20B, a dummy channel stack 301C may be grown from the barrier layer 301B such that a top surface T5 of the dummy channel stack 301C is at a level of or higher than the top surface T4 of the patterned middle isolation layer 315.

The dummy channel stack 301C may be an epitaxial structure grown from the active pattern 301A with the barrier layer 301B thereon at a lateral side of the 1^{st} channel stack CS1. The dummy channel stack 301C may be formed to prevent the active pattern 301A from being patterned when the 1^{st} channel stack CS1 with the upper portion of the middle isolation layer 315 and the protection layer 316 thereon is patterned to form a space S1 for a 1^{st} source/drain region in a next step. With the dummy channel stack 301C formed on the active pattern 301A, the dummy channel stack 301C, instead of the active pattern 301A, may be patterned along with the 1^{st} channel stack CS1 with the upper portion of the patterned middle isolation layer 315 and the protection layer 316 thereon. Thus, the active pattern 301A below the dummy channel stack 301C and the barrier layer 301B may not be etched to form a recess therein such as the recess R1 shown in FIGS. 6A and 6B.

To serve this purpose, the dummy channel stack 301C may be grown from the active pattern 301A with the barrier layer 301B thereon to have a height similar or corresponding to a height of the 1^{st} channel stack CS1 with the patterned middle isolation layer 315 and the protection layer 316 thereon by controlling an amount of epitaxy elements and/or a time duration of the epitaxy. For example, the dummy channel stack 301C may be grown such that the top surface T5 thereof is at the level or higher than the top surface T4 of the middle isolation layer 315, not being limited thereto. Further, the dummy channel stack 301C may be grown to be formed of a material such as Si, SiGe or a combination thereof which is the same as or similar to the materials forming the 1^{st} channel stack CS1 including the 1^{st} channel layers 312 and the 1^{st} sacrificial layers 311. The dummy channel stack 301C may not be doped with impurities.

However, the epitaxy in this step may be further controlled such that the top surface T5 of the dummy channel stack 301C is at the level or higher than the top surface T5 of the dummy channel stack 201B of the intermediate semiconductor device 20' shown in FIGS. 13A and 13B by a thickness of the barrier layer 301B along the D3 direction. By this additional control of the epitaxy for the height of the dummy channel stack 301C, the barrier layer 301B may remain on the top surface T3 of the active pattern 301A after the patterning of the dummy channel stack 301C along with the 1^{st} channel stack CS1 with the patterned middle isolation layer 315 and the protection layer 316 thereon.

Referring to FIGS. 21A and 21B, the 1^{st} channel stack CS1 with the lower portion of the middle isolation layer 315 and the protection layer 316 thereon may be patterned to provide the space S1 where the 1^{st} source/drain region, which is a lower source/drain region, is to be formed in a next step.

It is to be understood that, in this step, the 1^{st} channel stack CS1 with the lower portion of the middle isolation layer 315 and the protection layer 316 thereon may be removed only between and at sides of the dummy gate structures 350' along the D1 direction as shown in FIG. 6A, and thus, the 1^{st} channel stack CS1 as well as the 2^{nd} channel stack CS2 surrounded by or below the dummy gate structures 350' may not be patterned. Thus, these portions of the 1^{st} channel stack CS1 and the 2^{nd} channel stack CS2 surrounded by or below the dummy gate structures 350' may form a 1^{st} channel structure CH1 and a 2^{nd} channel structure CH2 thereabove surrounded by or below each of the dummy gate structures 350'. These two channel structures CH1 and CH2 may be shown in dashed lines in FIG. 21B which shows a cross-section view along a line II-II' of FIG. 21A.

Like the patterning operation performed on the intermediate semiconductor device 20' as shown in FIGS. 14A and 14B, the patterning operation in this step may be performed such that the 1^{st} channel layers 312 are entirely exposed along the D1 direction in the space S1 to facilitate epitaxial growth of the 1^{st} source/drain region from the 1^{st} channel layers 312 in the next step. Further, the patterning operation in this step may not remove a portion of the substrate 301, for example, a right portion of the active pattern 301A to form a recess in the active pattern 301A such as the recess R1 in the active pattern 101A as shown in FIG. 6B. This is because the dummy channel stack 301C and the barrier layer 301B formed on the top surface T3 of the active pattern 301A in the previous step may prevent formation of such recess in the active pattern 301A.

Further, the dummy channel stack 301C may be patterned along with the 1^{st} channel stack CS1 with the lower portion of the middle isolation layer 315 and the protection layer 316 thereon at a substantially same etch rate. Thus, when the 1^{st} channel stack CS1 is removed to expose the top surface T3 of the active pattern 301A, the dummy channel stack 301C may also be removed to expose the barrier layer 301B therebelow on the top surface T3 of the active pattern 301A. This is different from the intermediate semiconductor device 20' shown in FIGS. 14A and 14B in which the top surface T3 of the active pattern 201A is exposed when the dummy channel stack 201B thereabove is removed.

At this time when the 1^{st} channel stack CS1 is removed, the residues RE1 and RE2 of the middle isolation layer 315 may also be removed. However, the middle isolation layer 315 remaining on a left side surface of the 1^{st} channel stack CS1 may not be patterned entirely, and instead, a lower portion thereof may remain as a residue RE3 due to an etch selectivity or etch rate difference between the 1^{st} channel stack CS1 and the middle isolation layer 315 and a height difference between portions of the middle isolation layer 315 as shown in FIG. 21B. Further, a portion of the protection layer 316 may also remain on a left side surface of this residue RE3 of the middle isolation layer 315 after the 1^{st} channel stack CS1 is patterned.

Referring to FIGS. 22A and 22B, 1^{st} source/drain regions 313 may be formed from the 1^{st} channel structure CH1 including the 1^{st} channel layers 312 in the space S1 obtained by patterning the 1^{st} channel stack CS1 in the previous step (FIGS. 21A and 21B).

The 1^{st} source/drain regions 313 may be epitaxially grown mainly along the D1 direction from the 1^{st} channel layers 312 of the 1^{st} channel structure CH1 surrounded by or below the dummy gate structure 350', while the 1^{st} sacrificial layers 311 of the 1^{st} channel structure CH1 are covered by inner spacers formed at side surfaces thereof. When the epitaxial growth of the 1^{st} source/drain regions 313 is performed, the epitaxial structure forming the 1^{st} source/drain region 313 may be in-situ doped with n-type impurities such as phosphorus (P), arsenic (As), antimony (Sb), etc. or p-type impurities such as boron (B), gallium (Ga), or indium (In), etc.

Like in the intermediate semiconductor device 20' shown in FIGS. 15A and 15B, no portion of the 1^{st} source/drain region 313 is formed inside the substrate 301, for example, the active pattern 301A because a recess like the recess R1 formed in the substrate 101 of the intermediate semiconductor device 10' is not formed in the substrate 301 due to the barrier layer 301B and the dummy channel stack 301C formed in the previous steps (FIGS. 19A-19B and 20A-20B). Thus, current leakage like the current leakage that may be generated from the portion 113S of the 1^{st} source/drain region 113 formed inside the substrate 101 may be prevented or reduced in a stacked semiconductor device manufactured from the intermediate semiconductor device 20'.

Moreover, due to the barrier layer 301B formed on the top surface T3 of the active pattern 301A, which is a right portion of the top surface of the active pattern 301A, possible current leakage from the 1^{st} source/drain region 313 may be further prevented or reduced. This is because the barrier layer 301B with low concentration of impurities, which is of the same type as those in the 1^{st} source/drain region 313, may suppress carrier mobility from the 1^{st} source/drain region 313 into the substrate 301 as described in reference to FIGS. 19A and 19B, whether the 1^{st} source/drain region 313 is of n-type or p-type.

Referring to FIGS. 23A and 23B, 2^{nd} source/drain regions 323 may be formed from the 2^{nd} channel structure CH2 including the 2^{nd} channel layers 322 in the space S2 obtained by patterning the 2^{nd} channel stack CS2 in the previous step (FIGS. 10A and 10B).

The formation of the 2^{nd} source/drain regions 323 may be performed in the same or similar manner applied to the formation of the 2^{nd} source/drain region 223 of the intermediate semiconductor device 20' as shown in FIGS. 16A and 16B, and thus, duplicate descriptions thereof may be omitted herein.

Referring to FIGS. 24A and 24B, the dummy gate structures 350' and the 1^{st} and 2^{nd} sacrificial layers 311 and 321 respectively included in the 1^{st} and 2^{nd} channel structures CH1 and CH2 may be replaced by gate structures 350 to form a stacked semiconductor device 30.

The formation of the gate structure 350 may be performed in the same or similar manner applied to the formation of the gate structure 250 of the intermediate semiconductor device 20' as shown in FIGS. 17A and 17B, and thus, duplicate descriptions thereof may be omitted herein.

However, referring back to FIGS. 19A-19B to FIGS. 22A-22B, due to the barrier layer 301B and the dummy channel stack 301C grown based on the substrate 301, the substrate 301 may not be patterned when the 1^{st} channel stack CS1 is removed, and thus, no portion of the 1^{st} source/drain region 313 may be formed inside the substrate 301, thereby to prevent or reduce current leakage from the 1^{st} source/drain region 313 to the substrate 301. In addition, the barrier layer 301B may further suppress carrier mobility into the substrate 301 to further improve device performance of the stacked semiconductor device 30.

FIGS. 25A and 25B illustrate a flowchart of manufacturing a stacked semiconductor device using a dummy channel stack and a barrier layer, according to one or more embodiments.

The stacked semiconductor device to be manufactured through the flowchart of FIGS. 25A and 25B may be the same as or similar to at least one of the stacked semiconductor devices 20 and 30 manufactured in reference to FIGS. 10A-10B through 24A-24B.

In step S10, an initial semiconductor device including a 1^{st} channel stack on a substrate and a 2^{nd} channel stack vertically above the 1^{st} channel stack may be provided (FIGS. 1A and 1B). Each of the 1^{st} channel stack and the 2^{nd} channel stack may include a plurality of channel layers, which are nanosheet layers.

In step S20, the 2^{nd} channel stack may be patterned such that the 2^{nd} channel stack vertically overlaps a 1^{st} portion, among the 1^{st} portion and a 2^{nd} portion, of the 1^{st} channel stack (FIGS. 2A and 2B). As a result of the patterning of the 2^{nd} channel stack in this step, the 1^{st} channel stack may have a greater channel width and a smaller number of channel layers than the 2^{nd} channel stack.

In step S30, a dummy gate structure may be formed to surround the 1^{st} channel stack and the 2^{nd} channel stack (FIGS. 3A-3B and 4A-4B).

In step S40, the 2^{nd} channel stack and the 2^{nd} portion of the 1^{st} channel stack may be patterned based on the dummy gate structure to form a 1^{st} space vertically above the 1^{st} portion of the 1^{st} channel stack and expose a 2^{nd} potion, among a 1^{st} portion and the 2^{nd} portion, of a top surface of the substrate from which the 2^{nd} portion of the 1^{st} channel stack is removed (FIGS. 5A and 5B). The 1^{st} space is provided to form a 2^{nd} source/drain region in a later step, and the 2^{nd} portion of the top surface of the substrate is exposed to grow a dummy channel stack therefrom in a next step.

In step S50, a dummy channel stack may be formed on the 2^{nd} portion of the top surface of the substrate exposed in the previous step (FIGS. 18A-18B to FIGS. 20A-20B). The dummy channel stack may be epitaxially grown from the 2^{nd} portion of the top surface of the substrate such that a top surface of the dummy channel stack may be at a level of or higher than a top surface of the 1^{st} channel stack.

Prior to the formation of the dummy channel stack, a barrier layer may be formed on the 2^{nd} portion of the top surface of the substrate, and thus, the dummy channel stack may be formed on the barrier layer. The barrier layer may be formed of silicon and/or silicon germanium with impurities of less concentration than those to be doped in the 1^{st} source/drain region in a later step. The impurities doped in the barrier layer may be of the same type as those to be doped in the 1^{st} source/drain region.

In step S60, the 1^{st} channel stack and the dummy channel stack may be patterned to form a 2^{nd} space and expose the 1^{st} portion and the 2^{nd} portion of the top surface of the substrate (FIGS. 21A and 21B).

Due to the dummy channel stack, the 1^{st} portion and the 2^{nd} portion of the top surface of the substrate exposed by the patterning operation in this step may be substantially coplanar or aligned in a horizontal direction, that is, the D1 or D2 direction. Further, due to the dummy channel stack, when the 1^{st} channel stack is patterned, the 2^{nd} portion of the top surface of the substrate may avoid patterning thereon which may form a recess in the substrate. If such recess is formed in the substrate, the 1^{st} source/drain region to be formed in a next step may also be formed therein to generate or increase current leakage from the 1^{st} source/drain region into the substrate.

When the barrier layer is formed on the 2^{nd} portion of the top surface of the substrate prior to the formation of the dummy channel stack in the previous step, the barrier layer may remain after the dummy channel stack is patterned along with the 1^{st} channel stack. The barrier layer may serve to further reduce or better prevent current leakage from the 1^{st} source/drain region to the substrate by suppressing carrier mobility from the 1^{st} source/drain region.

In step S70, the 1^{st} source/drain region may be formed in the 2^{nd} space and the 2^{nd} source/drain region may be formed in the 1^{st} space followed by formation of a gate structure replacing the dummy gate structure, to complete formation of a stacked semiconductor device (FIGS. 22A-22B to 24A-24B).

In the above embodiments, the FETs respectively formed at the 1^{st} level and the 2^{nd} level are described as nanosheet transistors including nanosheet layers as channel layers. However, the disclosure is not limited thereto. According to one or more other embodiments, each of the FETs may be a nanosheet transistor, a FinFET, a forksheet transistor, or any other type of transistor.

FIG. 26 is a schematic block diagram illustrating an electronic device including one or more stacked semiconductor devices shown in FIGS. 17A-17B and 24A-24B, according to one or more embodiments.

Referring to FIG. 26, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus 1007.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (DRAM), a flash memory, etc.

At least one of the core 1011, the DSP 1012, the GPU 1013, and/or the embedded memory 1014 may include one or more of the stacked semiconductor devices shown in FIGS. 17A-17B and 24A-24B, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A stacked semiconductor device comprising:
a substrate;
a 1^{st} source/drain region on the substrate; and
a 2^{nd} source/drain region vertically above the 1^{st} source/drain region, the 2^{nd} source/drain region vertically overlapping a 1^{st} portion, among the 1^{st} portion and a 2^{nd} portion, of the 1^{st} source/drain region,
wherein a 1^{st} portion of a top surface of the substrate vertically below the 1^{st} portion of the 1^{st} source/drain region and a 2^{nd} portion of the top surface of the substrate vertically below the 2^{nd} portion of the 1^{st} source/drain region are coplanar or aligned.

2. The stacked semiconductor device of claim 1, wherein a 1^{st} side surface of the 1^{st} source/drain region and a 1^{st} side surface of the 2^{nd} source/drain region are vertically coplanar or aligned,
wherein a 2^{nd} side surface of the 1^{st} source/drain region and a 2^{nd} side surface of the 2^{nd} source/drain region are not vertically coplanar or aligned,
wherein the 2^{nd} side surfaces are opposite to the 1^{st} side surfaces, respectively.

3. The stacked semiconductor device of claim 2, further comprising:
a 1^{st} channel structure on the 1^{st} source/drain region;
a 2^{nd} channel structure on the 2^{nd} source/drain region; and
a middle isolation layer between the 1^{st} channel structure and the 2^{nd} channel structure,
wherein a residual structure having a same material composition as the middle isolation layer is formed at a lower portion of the 1^{st} side surface of the 1^{st} source/drain region.

4. The stacked semiconductor device of claim 3, further comprising a protection layer at a side surface of the residual structure.

5. The stacked semiconductor device of claim 1 or 2, further comprising:
a 1^{st} channel structure on the 1^{st} source/drain region, the 1^{st} channel structure comprising a plurality of 1^{st} nanosheet layers; and
a 2^{nd} channel structure on the 2^{nd} source/drain region, the 2^{nd} channel structure comprising a plurality of 2^{nd} nanosheet layers,
wherein a number of the plurality of 1^{st} nanosheet layers is greater than a number of the plurality of 2^{nd} nanosheet layers.

6. The stacked semiconductor device of any one of claims 1 to 5, further comprising a barrier layer on the 2^{nd} portion of the top surface of the substrate.

7. The stacked semiconductor device of claim 6, wherein the barrier layer comprises dopants of a same type as dopants in the 1^{st} source/drain region, and
wherein concentration of the dopants is lower in the barrier layer than in the 1^{st} source/drain region.

8. The stacked semiconductor device of any one of claims 1 to 5, further comprising a barrier layer on a bottom surface of the 2^{nd} portion of the 1^{st} source/drain region.

9. The stacked semiconductor device of claim 8, wherein the barrier layer comprises dopants of a same type as dopants in the 1^{st} source/drain region, and
wherein concentration of the dopants is lower in the barrier layer than in the 1^{st} source/drain region.

10. A stacked semiconductor device comprising:
a substrate;
a 1^{st} source/drain region on the substrate;
a 2^{nd} source/drain region vertically above the 1^{st} source/drain region, the 2^{nd} source/drain region vertically overlapping a 1^{st} portion, among the 1^{st} portion and a 2^{nd} portion, of the 1^{st} source/drain region; and
a barrier layer on a 2^{nd} portion, among a 1^{st} portion and the 2^{nd} portion, of a top surface of the substrate vertically below the 2^{nd} portion of the 1^{st} source/drain region.

11. The stacked semiconductor device of claim 10, wherein the barrier layer comprises dopants of a same type as dopants in the 1^{st} source/drain region, and
wherein concentration of the dopants is lower in the barrier layer than in the 1^{st} source/drain region.

12. The stacked semiconductor device of claim 11, wherein the barrier layer comprises silicon.

13. The stacked semiconductor device of any one of claims 10 to 12, wherein a 1^{st} side surface of the 1^{st} source/drain region and a 1^{st} side surface of the 2^{nd} source/drain region are vertically coplanar or aligned,
wherein a 2^{nd} side surface of the 1^{st} source/drain region and a 2^{nd} side surface of the 2^{nd} source/drain region are not vertically coplanar or aligned,
wherein the 2^{nd} side surfaces are opposite to the 1^{st} side surfaces, respectively.

14. The stacked semiconductor device of claim 13, further comprising:
a 1^{st} channel structure on the 1^{st} source/drain region;
a 2^{nd} channel structure on the 2^{nd} source/drain region; and
a middle isolation layer between the 1^{st} channel structure and the 2^{nd} channel structure,
wherein a residual structure having a same material composition as the middle isolation layer is formed at a lower portion of the 1^{st} side surface of the 1^{st} source/drain region.

15. The stacked semiconductor device of any one of claims 10 to 13, further comprising:
a 1^{st} channel structure on the 1^{st} source/drain region, the 1^{st} channel structure comprising a plurality of 1^{st} nanosheet layers; and
a 2^{nd} channel structure on the 2^{nd} source/drain region, the 2^{nd} channel structure comprising a plurality of 2^{nd} nanosheet layers,
wherein a number of the plurality of 1^{st} nanosheet layers is greater than a number of the plurality of 2^{nd} nanosheet layers.
